# EUROPEAN PATENT APPLICATION

(11) **EP 2 169 827 A1**
(43) Date of publication of application: **31.03.2010**
(21) Application number: 09169846.4
(22) Date of filing: 09.09.2009
(51) Int. Cl.: H03K 3/037, H03K 3/356, H03K 19/003

(54) **Low voltage, high speed data latch**

(30) Priority: 30.09.2008 US 286286
(71) Applicant: BAE SYSTEMS Information and Electronic Systems Integration, Inc., Nashua, NH 03061-0868 (US)
(72) Inventor: Lawson, David C, Haymarket, VA VA 20169 (US); Belzecky, Michael, Allentown, PA PA 18104 (US)
(74) Representative: Mackett, Margaret Dawn

(57) **Abstract**

Tri-stating transistors which are controlled by the latch enable lines isolate holding transistors from the latch node during setting of the latch. The tri-stating transistors are connected to the holding transistors and the latch node which allows the node to float and assume a third state during setting of the latch when the latch is enabled.

## Description

### STATEMENT OF GOVERNMENT INTEREST

The invention claimed in this application was made with United States Government support under Contract Number DTRA01-03-D-007-0005. The United States Government has certain rights in this invention.

### FIELD OF THE INVENTION

This invention relates to data latches, which are used in a radiation environment. A radiation hardened latch includes redundancy, which allows the latch to retain its state even when a latch node is disturbed by a single event upset (SEU), caused by radiation such as an alpha particle or heavy ion strike.

In prior art radiation hardened latches, operating voltage (Vdd) cannot be lowered sufficiently without adverse effects, such as poor data retention, and set up time of the latch is slow.

There is an advantage given to the designer of computer components utilizing the latches if a reduction in operating voltage is achieved. A reduced minimum operating voltage allows other components to operate with lower output voltages and lower power requirements. When the operating frequency of the latch (set up time required to store data in the latch) is increased, the overall speed of the device utilizing the latch also increases. A higher speed and a lower minimum voltage are advantages the invention affords the designer of systems using latches.

### SUMMARY OF THE INVENTION

Many electronic applications require highly reliable data latches, register files, and random access memories (RAMs) that use redundant architectures of separate circuit elements to prevent a single event upset (SEU) in one element from affecting data storage. Such data storage architectures are slow to accept new data and require high minimum operating voltages (Vdd). It is necessary to isolate nodes of data storage elements from holding transistors to decrease the setup time for new data and reduce operating voltage (Vdd).

In this invention a tri-stateable node includes a pull-up transistor to a positive power supply Vdd and a pull-down transistor to ground. Two tri-stating transistors isolate the internal node of an inverter, when receiving the data output of the transmission gate at the time the latch is enabled.

According to the present invention, there is provided a radiation hardened latch having an additional four transistors, which isolate pull up and pull down the transistors (holding transistors) from two latch nodes when data is set in the latch.

In the prior art radiation hardened latch, when data is applied to a latch node while enabled during set up, the holding transistor which holds the latch in its prior state remains slightly on or does not immediately turn off. When this occurs, some holding transistor voltage remains on the node until a time when current from the data input overcomes the holding transistor voltage.

Therefore, in accordance with this invention, an additional tri-stating transistor is provided with each input holding transistor, which will isolate the holding transistor from the node during data input. The additional tri-stating transistor turns off during the time the enable signal is present which is when new data is sent to the latch node. The additional tri-stating transistor is controlled by the data enable lines and as soon as the data enable lines are on, the tri-stating transistor turns off. The additional tri-stating transistor ceases conducting and thereby isolates the internal node and holding transistor. The additional tri-stating transistor is turned on when the enable changes state and new data is held in the latch.

### BRIEF DESCRIPTION OF THE DRAWINGS

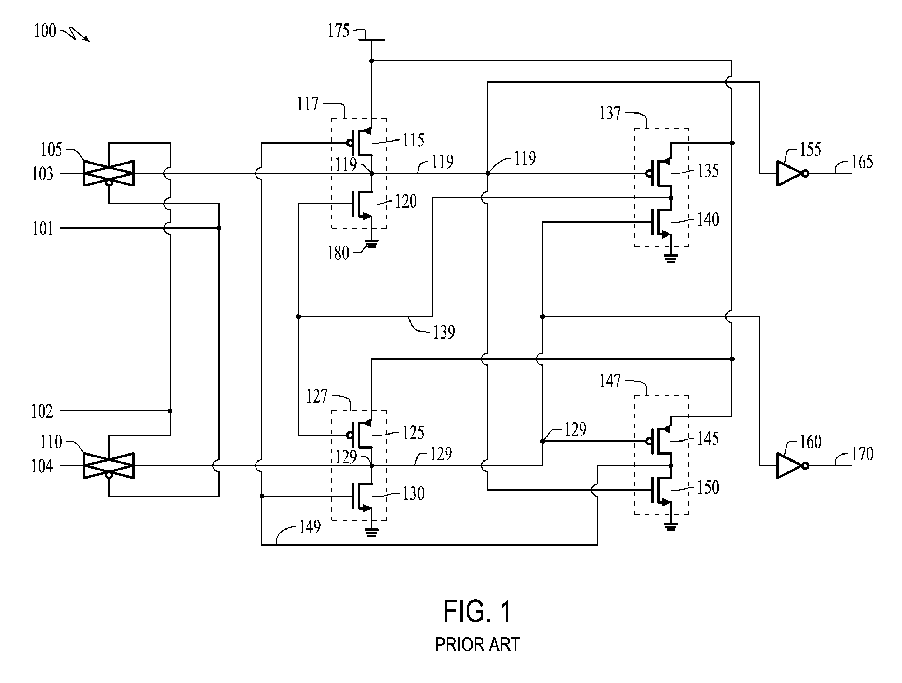

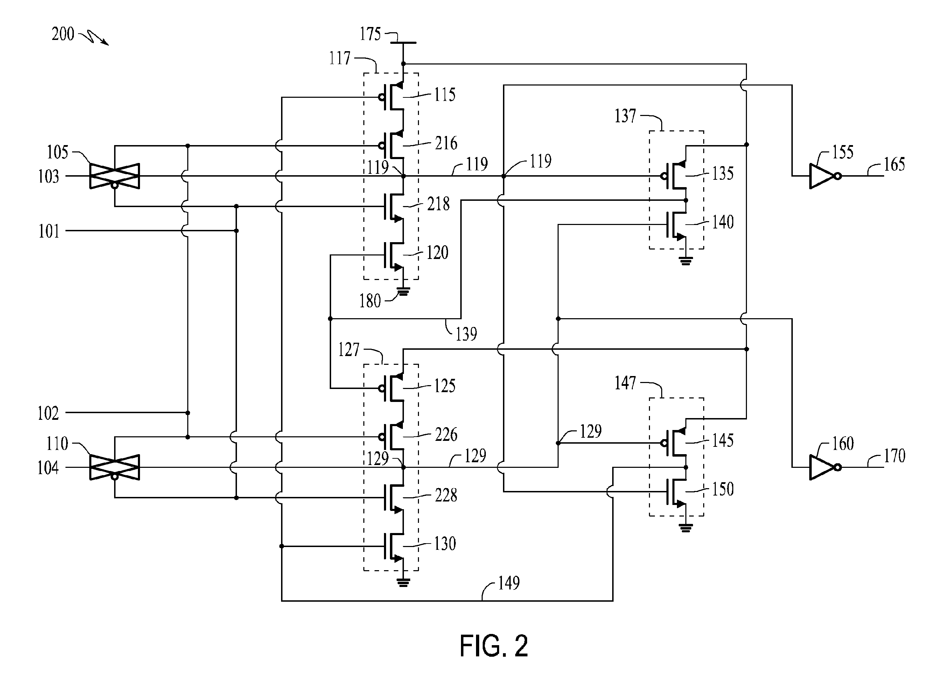

For a better understanding of the present invention, reference will now be made, by way of example only, to the accompanying drawings in which the elements of Figures 1 and 2 which are the same have the same reference numbers:-
Fig. 1 shows an example of a redundant prior art data latch;
Fig. 2 shows an example of a low voltage high speed redundant data latch.

### DETAILED DESCRIPTION

Fig. 1 shows a prior art radiation hardened data latch 100 that includes data input lines, 103 and 104 and buffered output lines 165 and 170. The data input lines 103 and 104 carry a redundant input signal. The data output lines 165 and 170 carry a redundant output signal. Input lines 103 and 104 are the input signals for a data bit to be stored in the data latch 100. When the latch is set (not enabled), the transmission gates 105 and 110 are switched to high impedance, non-transmissive state by the top and bottom enable lines 101 and 102.

The data latch 100 includes inverters 117, 127, 137, and 147 that are structurally identical. Inverters 117 and 137 have a node 119 and inverters 127 and 147 are redundant to inverters 117 and 137 and have a node 129. Inverters 117 and 127 invert the two feed back signals on lines 139 and 149 which are connected to the output of inverters 137 and 147. Inverters 117 and 127 are physically separated on a monolithic or hybrid integrated chip or module so that SEU induced loss of node charge at 119 or 129 does not cause the data latch 100 to loose the stored data bit. The spatial diversity and redundancy of the inverters 117 and 127 make the data latch 100 immune to the effects of a high-energy particle strike or single event upset (SEU).

If an internal node 119 or 129 of an inverter 117 or 127 is hit by a particle, the charge on the affected internal node will be depleted. However, because the internal nodes 119 and 129 are physically separated, the data latch 100 does not change states. Nodes 119 and 129 provide a redundant state in the data latch 100 which hold the state of the data latch 100. The lower portion (inverters 127 and 147) of Fig. 1 is redundant to the upper portion (inverters 117 and 137).

Unfortunately the data latch 100 is slow to change state when new data is presented at inputs 103 and 104 during enable. The slowness of the data latch 100 is due to the current flowing in transistor 115 (when node 119 is a 1) which must be overcome by power from the data line 103. In this case the transistor 115 and the circuitry driving input line 103 constitute a voltage divider which prevents the data storage node 119 from immediately changing states. When an input data is transmitted through the transmission gate 105 to the internal node 119 of the cross-coupled inverter 117, the signal sets to the state of the node to a "1" or a "0" depending on the data value. The data state of node 119 then propagates to the inverters 137 and 147 and the output buffer 155. A similar slowness exists when current is flowing in transistor 120 and a 0 is stored on node 119.

Data latch 100 is resistant to radiation induced upset by virtue of using internal nodes 119 and 129 that are broken up (separated) or are spatially diverse to provide redundant data retention which allows the latch to restore even in the case of an SEU strike which upsets one of the nodes. In other words, the radiation-hardened aspect of the data latch 100 is due to routing the internal nodes of each inverter to other.

Fig. 1 shows an example of a prior art data latch 100 that includes transmission gates 105 and 110, p-channel transistors 115, 125, 135, and 145, n-channel transistors 120, 130, 140, and 150, and output inverting buffers 155, and 160. The p-channel transistors 115, 125, 135, and 145 are connected to a common power supply voltage 175 while n-channel transistors 120, 130, 140, and 150 are connected to ground. The data latch 100 implements a redundant latch structure that connects the output of the feedback inverters 137 and 147 into the input feed forward inverters 117 and 127. When the feedback line 139 is a "1," it turns on the n-channel transistor 120 and turns off the p-channel transistor 125 and the feedback line 149 redundantly turns on the n-channel transistor 130 and turns off the p-channel transistor 115. The signal lines 139 and 149 supply the outputs of the feedback inverters 137 and 147 to feed forward inverters 117 and 127 to retain a state of the data latch 100 despite an incident, such as a radiation particle strike. Nodes 119 or 129 do not change because of this feedback.

The n-channel transistors 120, 130, 140, 150 and p-channel transistors 115, 125, 135, 145 store one bit of information in the data latch 100. Inverting buffers 155 and 160 augment the drive for current sourcing and sinking capability of the feed forward inverters 117 and 127 to drive output lines 165 and 170 respectively.

The transmission gates 105 and 110 are enabled by control lines 101 and 102. When enabled, transmission gates 105 and 110 pass the state of data input lines 103 and 104 into the internal nodes 119 and 129 of the feed forward inverters 117 and 127. In this specification high refers to a "1" and low refers to a logical "0." In other words, during enable the control line 101 is driven low (a "0") and the control line 102 is driven high (a "1") so that the input line 103 state is injected into an internal node of the inverter 117 and onto node 119 while the input line 104 state is injected into an internal node 129 of the inverter 127.

When data is changed the holding currents at nodes 119 and 129 compete with the sink or source currents on the data lines 103 and 104 (the output of the transmission gates 105 and 110, respectively). For a brief time, the transmission gate 105 and either the P-channel transistor 115 or the n-channel transistor 120 simultaneously drive the internal node of the feed forward inverter 117 that produces the node 119 current. The time needed to set the redundant internal nodes 119, 129 of the feed forward inverters 117 and 127 increases when the drive currents from the transmission gates 105 and 110 compete with the holding currents produced by the holding transistors 115, 120, 125 and 130.

The invention can best be understood by reference to Figure 2 and the response of inverter 117 to a data input at line 103 and enabling at lines 101 and 102. When the latch is in a set condition where node 119 is high (logical 1), holding transistor 115 and tri-stating transistor 216 are both turned on. In this state, the latch is in its latched condition and holds data and it is not enabled. When it is desired to change the state of the latch, an enabling signal is applied to lines 101 and 102. When a "0" is written into the latch, the signal from enable line 102 also turns off tri-stating transistor 216. This stops current flowing from holding transistor 115 and allows the node 119 to float or assume a third state, which is neither high nor low. When the node 119 is not driven by holding transistor 115 (tri-stating transistor 216 is turned off), it is in a third floating state. This third state on node 119 is caused by tri-stating transistor 216 turning off. At this time, when data is applied to terminal 103, the data immediately appears at node 119, and is not interfered with by current, which would otherwise be present due to holding transistor 115. This improves set up time and reduces the required data input voltage to set the latch. The state of the latch can be set with a lower data input voltage.

This is unlike the prior art (Fig. 1) where without the presence of a tri-stating transistor 216, the current flowing through holding transistor 115 and the current from the transmission gate 105 at node 119 form voltage divider. For this reason, in the prior art, the voltage and at node 119 does not immediately reach logical "0".

The circuit of this invention provides a faster response time because the transistor 216 is turned off by the data enable 102. Stated another way, if there is no transistor 216, then a "0" at node 119 is not "hard" and transistor 135 will not be fully turned on, which in turn causes the turn-on time of transistor 120 to be slow.

An important advantage of this invention is the change in minimum operating voltage achieved. In the latch of the prior art (Fig. 1) as compared to the latch of this invention (Fig. 2), the minimum operating voltage of the prior art latch was determined to be 0.95 V by simulation. On the other hand, the minimum operating voltage of the latch of this invention was determined to be 0.7 V by simulation. This improvement in minimum operating voltage is achieved by the isolation of holding transistor 115 by the turning off of tri-stating transistor 216. The reason is that upon turn off of tri-stating transistor 216, the node 119 goes to its third state (floating condition) where it can quickly turn on transistor 135 without overcoming voltage from holding transistor 115, which is otherwise present. For instance, in the prior art the voltage at node 119 may be near Vdd due to holding transistor 115. This voltage must be overcome by the voltage from the data source 103. The data source voltage 103 therefore must exceed the voltage due to holding transistor 115 in an amount sufficient to turn on transistor 135.

The tri-stated node condition is best understood by first considering the state of the latch 200 where a logical 1 is on node 119. Here enable line 101 has a logical 1 and enable 102 has a logical 0 and the latch is set and not accepting new input data. Transistors 115, 216 and 218 are on and transistor 120 is off. The latch stores a 1 at node 119 until it is enabled and the input data is changed. The redundant portion of the latch 200 has transistors 125, 226 and 228 turned on and transistor 130 turned off. The redundant portion also has a 1 at node 129.

When the latch has a logical 0 on node 119, transistors 216, 218 and 120 are turned on and transistor 115 is turned off. The redundant portion has transistors 226, 228 and 130 turned on and transistor 125 turned off. The redundant portion has a "0" at its node 129. Enable line 101 has a 1 and enable line 102 has a 0 during this steady state and the latch holds the data at its redundant nodes 119 and 129.

When the latch is in the first steady state with a 1 on node 119 and the data at 119 is to be changed to a 0, the following sequence occurs. When enabled, control line 102 changes from 0 to 1 thereby turning off transistor 216. The turning off of transistor 216 cuts off any current from transistor 115 thereby allowing data from line 103 and gate 105 to drive the node 119 to an enabling 0 with a lower drive voltage and in a faster time because the node 119 is disconnected from transistor 115. At this time the transistor 218 is turned off by a 0 on line 101. The node 119 therefore floats or is in a tri-state when transistors 216 and 218 are both off. At this time the node 119 is driven at a higher speed and with a lower voltage by the data input from 103. The node 119 is at 0 when transistors 216 and 218 are off because of current from input 103. The redundant transistors 125, 226, 228 and 130 operate the same way at the same time and node 129 is changed from a 1 to a 0.

The latch is set when the enable lines return to the state when line 101 is a 1 and line 102 is a 0 (the latch is no longer enabled). Upon setting of the latch, transistor 218 turns on. Transistor 218 and 120 then hold node 119 at 0 until an enable signal and new data is received. New data is sent from data line 103 and drive 105 and the latch is reset. The redundant portion (transistors 125, 225, 228 and 130) operate in the same way.

The radiation hardened feature of the latch is provided because if either node 119 or 129 looses data, the latch will restore to the state of the other redundant node.

Fig. 2 is an example of a low voltage high speed data latch 200 that includes transmission gates 105 and 110, modified feed forward inverters 117 and 127. Feed forward inverters 117 and 127 are modified by including additional tri-stating transistors 216, 218, 226 and 228.

The feed forward inverter 117 has a p-channel transistor 115, a tri-stating p-channel transistor 216, a tri-stating n-channel transistor 218, and an n-channel transistor 120. The tri-stating p-channel transistors 216 and 226 switch from a high-impedance state to a conductive state when the control line is switched to low. The n-channel transistors 218 and 228 are switched from a high-impedance state to a low-impedance state when the control line 101 is switched to high. The control lines 101 and 102 present opposite polarity or complementary enable control signals to the tri-stating p-channel and n-channel transistors 216, 218, 226, and 228 that isolate the internal nodes 119 of the and 129 from holding transistors 115, 120, 125 and 130 of feed forward inventers 117 and 127 during enable. The isolation from the holding transistors causes nodes 119 and 129 to float or be at a third state (tri-state).

The internal node 119 of the input inverter 117, i.e., the node connected to the feed forward line 119 is disconnected from the effects of feedback on the feedback line 149 which controls transistor 115 when the control line 102 is high. Simultaneously, the control lines 101 and 102 enable the transmission gates 105 and 110. The tri-stating p-channel transistor 216 and the tri-stating n-channel transistor 218 provide a high-impedance disconnect feature (floating node third state) to the low voltage and high speed data latch 200 that allows the data from the transmission gates 105 and 110 to immediately control nodes 119 and 129. The tri-stating p-channel transistor 226 and tri-stating n-channel transistor 228, along with the transmission gate 110, provide a corresponding feature to the redundant feed forward inverter 127.

Table 1 shows the states of control line 101 when the data is received on the node 119 and 129, and when the latch is set. When the control line 101 is high ("1 ") and the control line 102 is low ("0") the tri-stating p-channel transistors 216 and 226 and the tri-stating n-channel transistors 218 and 228 are on. When the control line 101 is low and control line 102 is high then the impedance of the tri-stating p-channel transistors 216, 218, 226 and the impedance of n-channel transistors 218 and 228 are high which effectively disconnects the holding transistors from the node. The control lines also simultaneously enable the transmission gates 105 and 110 to send the data on the input line 103 onto the node 119 and 129.

**TABLE 1**

| Enable line 101 level | Control of inverter 117 |
|---|---|
| High | Latch is set |
| Low | Receives data, Latch enabled |

The method includes a step of disconnecting transistors connected to an output node of a feed forward inverter so that the output node is unaffected by feedback signals from redundant feedback inverters of the data latch.

While the invention has been described in conjunction with the specific exemplary embodiments thereof, it is evident that many alternatives, modifications, and variations will be apparent to those skilled in the art. Accordingly, embodiments of the invention as set forth herein are intended to be illustrative, not limiting. There are changes that may be made without departing from the spirit and scope of the invention.

## Claims

1. A latch circuit comprising:
at least one holding transistor;
an enable line;
a data line;
a latch node;
at least one tri-stating transistor having its gate connected to the enable line and connected with the least one holding transistor and to the node; and
wherein the tri-stating transistor is turned off when the enable line is enabled.

2. A latch circuit according to claim 1, wherein the latch node floats when the tri-stating transistor is turned off.

3. A latch circuit according to claim 1 or 2, wherein current flowing from the at least one holding transistor is removed from the latch node when the tri-stating transistor is turned off.

4. A radiation hardened latch circuit comprising:-
an inverter which receives input data, the inverter having a node, a pull up transistor and a pull down transistor connected to the node;
a first tri-stating transistor connected to the node and the pull up transistor which is turned off by a latch enable signal when the input data is received; and
a second tri-stating transistor connected to the pull down transistor and the node which is turned off by the latch enable signal.

5. A method for storing data comprising the steps of driving a latch node high or low when the latch is not enabled; and allowing the latch node to float when the latch is enabled.

6. A method according to claim 5, further comprising the step of turning off a tri-stating transistor when the latch is enabled.

7. A method according to claim 5 or 6, wherein float occurs when the latch node is not driven high or low when the latch is enabled.

8. A method according to any one of claims 5 to 7, further comprising the step of inputting data to the latch node when the latch node is floating in a third state.

9. A data latch comprising:-
a first input stage including:
a first pull-up transistor that inverts a first feedback signal to generate a first node signal at a first internal stage node when an enable is off;
a first pull-down transistor that inverts a second feedback signal to generate the first node signal when the enable is off;
a first tri-stating pull-up transistor, coupled to the first stage internal node, that isolates the first input stage internal node from the first pull-up transistor when the enable is on;
a first tri-stating pull-down transistor, coupled to the first stage internal node, that isolates the first input stage internal node from the first pull-down transistor when the enable is on;
a redundant input stage including:
a second pull-up transistor, coupled to a second input stage internal node, that inverts the second feedback signal to generate a second node signal when the enable is off;
a second pull-down transistor, coupled to the second input stage internal node, that inverts the first feedback signal to generate the second node signal when the enable is off;
a second tri-stating pull-up transistor that isolates the second input stage internal node from the second pull-up transistor when the enable is on;
a second tri-stating pull-down transistor that isolates the second input stage internal node from the second pull-down transistor when the enable is on;
a first feedback stage that inverts the first node signal to generate the first feedback signal;
a second feedback stage that inverts the second node signal to generate the second feedback signal; and
a first transmission gate which couples an input signal to the first input stage internal node when the enable is on and which isolates the first input stage internal node from the input signal when the enable is off; and
a second transmission gate which couples a redundant input signal to the second input stage internal node when the enable is on and which isolates the second input stage internal node from the redundant input signal when the enable is off.

10. A data latch according to claim 9, further comprising:
a first output buffer, coupled to the first input stage, that increases a first drive current of the first input stage; and
second output buffer, coupled to the second input stage that increases a second drive current of the second input stage.

11. A data latch according to claim 9 or 10, wherein the first and second tri-stating pull-up transistors are p-channel transistors and the first and second tri-stating pull-down transistors are an n-channel transistors.

12. A data latch according to any one of claims 9 to 11, wherein the first tri-stating pull-up transistor couples a first pull-up transistor to the first stage internal node when the enable is off.

13. A data latch according to any one of claims 9 to 11, wherein the first tri-stating pull-down transistor couples a first pull-down transistor to the first stage internal node with the enable line is off.

14. A data latch according to any one of claims 9 to 13, wherein the first feedback stage comprises:
a first feedback stage p-channel transistor that generates the second feedback signal by inverting the first node signal; and
a first feedback stage n-channel transistor, coupled to the first feedback stage p-channel transistor that generates the second feedback signal by inverting the second node signal.

15. A data latch according to any one of claims 9 to 14, wherein the second feedback stage comprises:
a second feedback stage p-channel transistor that generates the first feedback signal by inverting the second node signal; and
a second feedback stage n-channel transistor, coupled to the second feedback stage p-channel transistor that generates the first feedback signal by inverting the first node signal.
